(19) Europäisches Patentamt / European Patent Office / Office européen des brevets

(11) **EP 2 578 726 B1**

(12) **EUROPEAN PATENT SPECIFICATION**

(45) Date of publication and mention of the grant of the patent:
**17.10.2018 Bulletin 2018/42**

(21) Application number: **11789591.2**

(22) Date of filing: **12.05.2011**

(51) Int Cl.:
*C23C 28/04* [(2006.01)]  *C23C 28/00* [(2006.01)]
*C23C 16/26* [(2006.01)]  *C23C 16/515* [(2006.01)]

(86) International application number:
**PCT/JP2011/060977**

(87) International publication number:
**WO 2011/152182 (08.12.2011 Gazette 2011/49)**

(54) **METHOD FOR MANUFACTURING A COATED MEMBER**

VERFAHREN ZUR HERSTELLUNG EINES BESCHICHTETEN ELEMENTS

PROCÉDÉ DE FABRICATION D'UN ÉLÉMENT REVÊTU

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2010 JP 2010124552**

(43) Date of publication of application:
**10.04.2013 Bulletin 2013/15**

(73) Proprietor: **JTEKT Corporation**
**Osaka-shi, Osaka 542-8502 (JP)**

(72) Inventors:
• **SUZUKI, Masahiro**
  **Osaka-shi**
  **Osaka 542-8502 (JP)**
• **YAMAKAWA, Kazuyoshi**
  **Osaka-shi**
  **Osaka 542-8502 (JP)**
• **SAITO, Toshiyuki**
  **Osaka-shi**
  **Osaka 542-8502 (JP)**

(74) Representative: **TBK**
**Bavariaring 4-6**
**80336 München (DE)**

(56) References cited:
EP-A1- 2 444 520    JP-A- 2004 307 935
JP-A- 2004 323 973    JP-A- 2007 126 732
JP-A- 2008 173 936    JP-A- 2008 173 936
JP-A- 2009 035 584    JP-A- 2009 174 039
JP-B1- 4 372 833    US-A1- 2007 259 184

• A Stoica ET AL: "Plasma Enhanced Chemical Vapor Deposition of Diamond-like Carbon Coatings on Polymer Substrates", , 1 January 2009 (2009-01-01), XP055348247, Retrieved from the Internet: URL:http://citeseerx.ist.psu.edu/viewdoc/download?doi=10.1.1.186.8378&rep=rep1&type=pdf [retrieved on 2017-02-21]
• MASAHIRO SUZUKI ET AL.: 'The effect of pre-sputtering on running-in process in friction of DLC film' ZAIRYO GIJUTSU vol. 28, no. 1, 25 January 2010, pages 14 - 20, XP008169894
• MASAHIRO SUZUKI ET AL.: 'The effect of pre-sputtering on tribological properties of DLC films' ZAIRYO GIJUTSU vol. 27, no. 6, 2009, pages 225 - 230, XP008169904
• P. DVORAK ET AL.: 'Plasma deposition of diamond- like protective coating with silicon oxide content' 46TH ANNUAL TECHNICAL CONFERENCE PROCEEDINGS, 2003 SOCIETY OF VACCUM COATERS vol. 46, 2003, pages 541 - 545, XP008169906
• KAZUYUKI NAKANISHI ET AL.: 'Chokuryu Plasma CVD-ho ni yoru DLC-Si-maku no Tairyo Shori no Kento' THE SURFACE FINISHING SOCIETY OF JAPAN KOEN TAIKAI KOEN YOSHISHU vol. 112TH, 2005, page 88, XP008170133

**Description**

TECHNICAL FIELD

The present invention relates to a method of producing a coated member having a base surface at least partly coated with a DLC film.

BACKGROUND ART

For reduction of fuel consumption of motor vehicles, for example, slidable members to be mounted in the motor vehicles are required to have a reduced sliding resistance. To meet the requirement, at least a part of a surface of a base of such a slidable member is often coated with a DLC (Diamond-Like Carbon) film having a low-friction property and a wear resistance (higher hardness).

The DLC film is formed, for example, by a plasma CVD (Plasma Chemical Vapor Deposition) process. More specifically, a treatment chamber in which the base is accommodated is evacuated to vacuum. Then, a feedstock gas containing a carbon compound such as methane, hydrogen gas, argon gas and the like is continuously introduced into the treatment chamber, and the internal pressure of the treatment chamber is reduced to a predetermined treatment pressure level. While the treatment chamber is maintained at the reduced pressure level, a voltage is applied to the base to generate plasma in the treatment chamber. Thus, ions and radicals are generated from the feedstock gas, and chemical reactions are allowed to proceed on the surface of the base, whereby a film (DLC film) mainly containing C (carbon) is deposited on the surface of the base.

A DC (direct current) plasma CVD process in which a DC voltage is applied to the base, or a DC pulse plasma CVD process in which a DC pulse voltage is applied to the base is employed as the plasma CVD process.

Where Si (silicon) is contained in the formed DLC film, the DLC film is improved in adaptability during early use (hereinafter referred to as "initial adaptability") to be thereby imparted with an excellent low-friction property even during early use. Therefore, an organic silicon compound is added as a Si material to the feedstock gas in the plasma CVD process.

Typical examples of the organic silicon compound include silane compounds such as tetramethylsilane. In a DLC film forming step in which the treatment pressure in the treatment chamber is maintained at a higher degree of vacuum (at a lower pressure level) on the order of 20 Pa or lower in the plasma CVD process, hexamethyldisilazane, hexamethyldisiloxane or the like is often used instead of the silane compound as disclosed in PTL1.

In the DLC film forming step to be performed at the higher degree of vacuum, however, the amount of the feedstock gas to be introduced into the treatment chamber is reduced. Therefore, the DLC film forming rate is lower, requiring a longer period of time for forming a DLC film having a predetermined thickness. This reduces the productivity of the slidable member.

Further, the base is continuously subjected to the plasma for a long period of time and, therefore, is liable to be significantly damaged due to the accompanying temperature elevation. This reduces the range of choices for a material for the base. That is, the DLC film can be formed only on a surface of a base made of a material capable of sufficiently enduring the damage.

CITATION LIST

PATENT LITERATURE

PTL1: JP-2009-185336A

SUMMARY OF INVENTION

TECHNICAL PROBLEM

An attempt is made to employ a DLC film forming step in which the treatment pressure is maintained at a lower degree of vacuum (at a higher pressure level) on the order of not lower than 100 Pa and not higher than 400 Pa in the plasma CVD process. Thus, the partial pressures of a carbon compound as a C material and the silane compound as the Si material for film constituents can be increased in the treatment pressure to improve the film forming rate.

In the DLC film forming step to be performed at the lower degree of vacuum, however, a great amount of the organic silicon compound should be continuously introduced into the treatment chamber during the film formation in order to maintain the predetermined partial pressures in the treatment pressure.

However, hexamethyldisilazane, for example, is in a liquid phase under ordinary temperature and ordinary pressure conditions, and has a high boiling point on the order of about 125°C at the ordinary pressure. In order to continuously vaporize and introduce a great amount of hexamethyldisilazane into the treatment chamber at the lower degree of vacuum in the DLC film forming step, a vaporization/supply device including a heater, for example, should be provided and, in the DLC film forming step, the vaporization/supply device should be continuously operated. This results in additional problems such that the construction and the operation of the plasma CVD device are complicated and a greater amount of energy is required for the operation of the device.

On the other hand, tetramethylsilane, for example, has a low boiling point on the order of 26°C at the ordinary pressure. Therefore, tetramethylsilane is free from the aforementioned problems, because tetramethylsilane can be smoothly vaporized at the ordinary temperature simply in contact with a reduced pressure atmosphere in the treatment chamber without particular need for heating or the like. Accordingly, it is a common practice to use tetramethylsilane as the organic silicon compound in the DLC film forming step to be performed at the lower degree of vacuum.

According to studies conducted by the inventor of the present invention, however, where a feedstock gas containing the silane compound such as tetramethylsilane is used in the DLC film forming step to be performed at the lower degree of vacuum, it is impossible to sufficiently provide the effect of improving the DLC film forming rate even with the treatment pressure increased as described above.

That is, if the treatment pressure in the treatment chamber is increased to the aforementioned range, the partial pressures of the carbon compound as the C material and the silane compound as the Si material are increased. However, the DLC film forming rate is not sufficiently improved as corresponding to the increase in the partial pressures.

Currently, the problem that the productivity of the coated member such as the slidable member is lower and the problem that the base is continuously subjected to the plasma for a long period of time and is liable to be significantly damaged due to the accompanying temperature elevation are yet to be completely solved. Particularly, the damage to the base tends to be increased, as the treatment pressure increases.

JP2008173936 uses a pressure of 1-50 Pa for making a DLC-film by plasma CVD, and in the example with HMDSO, the pressure used during deposition is 15 Pa.

It is an object of the present invention to provide a coated member production method, which increases a DLC film forming rate at which a DLC film is formed on at least a part of a surface of a base of a coated member, thereby minimizing a damage to the base.

SOLUTION TO PROBLEM

According to one embodiment of the present invention, there is provided a coated member production method for producing a coated member including a base having a surface at least partly coated with a DLC film, the method comprising a DLC film forming step of the base (4) is accommodated in a treatment chamber (3), the treatment chamber(3) is evacuated to a predetermined degree of vacuum by the first pump (17), the treatment chamber (3) is evacuated to a predetermined degree of vacuum by the first and second pumps (17, 18), the second pump (18) is stopped and the treatment chamber (3) is continuously evacuated only by the first pump (17), introducing a feedstock gas containing at least a carbon compound and a siloxane compound (hereinafter also referred to as an oxygen-containing organic silicon compound) into a treatment chamber in which the base is accommodated, and applying a voltage to the base at a treatment pressure of not lower than 100 Pa and not higher than 400 Pa to generate plasma to form the DLC film on the surface of the base (Claim 1).

According to this method, the oxygen-containing organic silicon compound is selected to be used instead of the conventional silane compound such as tetramethylsilane as the organic silicon compound to be added to the feedstock gas. This significantly improves the DLC film forming rate at which the DLC film is formed on the surface of the base at the lower degree of vacuum in the DLC film forming step over the prior art employing tetramethylsilane, though the mechanism for the improvement is not clarified.

This further improves the productivity of the coated member with the base surface at least partly coated with the DLC film over the current state of the art, and minimizes the damage to the base of the coated member. This makes it possible to expand the range of choices for a material for the base.

In the coated member production method, the oxygen-containing organic silicon compound may be hexamethyldisiloxane (Claim 2).

According to this method, the boiling point of hexamethyldisiloxane is 100°C at the ordinary pressure, and about 70°C in a treatment pressure range of not lower than 100 Pa and not higher than 400 Pa in the treatment chamber. Therefore, hexamethyldisiloxane can be sufficiently vaporized in contact with a reduced pressure atmosphere in the treatment chamber by relatively moderate heating to less than 100°C at a reduced pressure, e.g., by heating a container containing hexamethyldisiloxane in a hot water bath.

This suppresses the complication of the construction and the operation of the plasma CVD device and the increase in the energy required for the operation. In addition, hexamethyldisiloxane is easily available and less expensive, thereby further improving the productivity of the coated member.

In the DLC film forming step, either the DC plasma CVD process or the DC pulse plasma CVD process may be employed. Particularly, the DC pulse plasma CVD process is preferably employed.

In the coated member production method, the plasma may be generated by applying a DC pulse voltage to the base in the DLC film forming step (Claim 3).

In this method, i.e., in the DC pulse plasma CVD process, it is possible to further stabilize the plasma generated in the treatment chamber, as compared with a case in which the plasma is generated by applying a DC voltage to the base in the DC plasma CVD process, while suppressing abnormal electric discharge which may lead to elevation of temperature. The damage to the base due to the temperature elevation can be minimized, for example, by controlling the treatment temperature at not higher than 300°C.

The DLC film formed by the DC pulse plasma CVD process has a smooth surface and, in addition, contains Si, so that the initial adaptability can be further improved.

According to the coated member production method, the DLC film forming rate is increased as much as possible, making it possible to further improve the productivity of the coated member with the base surface at least partly coated with the DLC film over the current state of the art and minimize the damage to the base of the coated member.

The foregoing and other objects, features and effects of the present invention will become more apparent from the following description of embodiments with reference to the attached drawings.

BRIEF DESCRIPTION OF DRAWINGS

FIG. 1 is a schematic sectional view showing an exemplary plasma CVD device to be used in a coated member production method according to one embodiment of the present invention.

FIG. 2 is a sectional view illustrating a subsurface portion of a coated member produced by the production method using the plasma CVD device.

FIG. 3 is a graph showing an exemplary waveform of a DC pulse voltage applied to a base from a power source of the plasma CVD device.

FIG. 4 is a graph showing the nano-indention hardnesses of DLC films of Examples and Comparative Example.

FIG. 5 is a graph showing exemplary Raman spectra of the DLC films of Examples and Comparative Example.

FIG. 6 is a graph showing a Raman spectrum of a DLC film of Example 1 with its waveform divided into a G-band and a D-band.

FIG. 7 is a graph showing a Raman spectrum of a DLC film of Comparative Example 2 with its waveform divided into a G-band and a D-band.

DESCRIPTION OF EMBODIMENTS

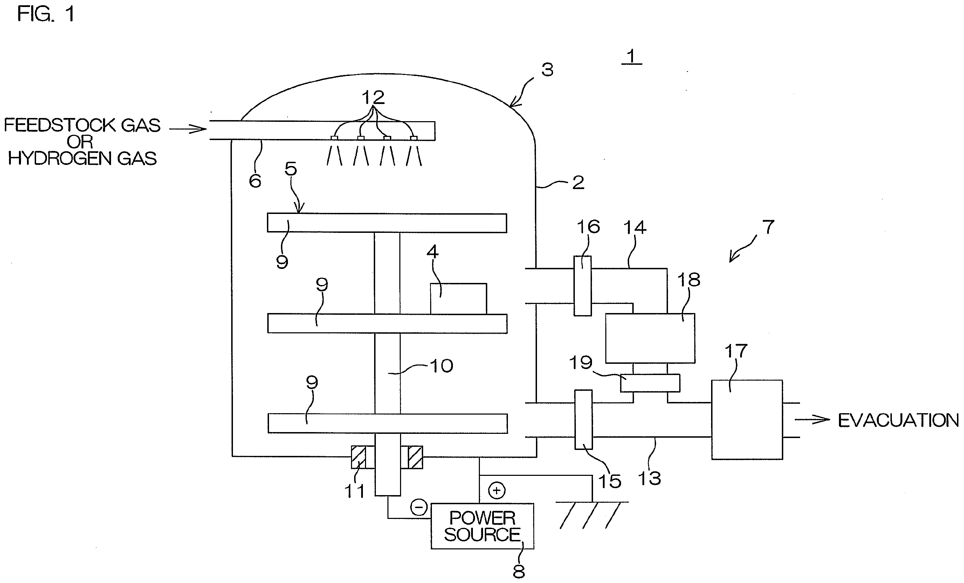

FIG. 1 is a schematic sectional view showing the construction of a plasma CVD device 1 to be used in a production method for a coated member 20 according to one embodiment of the present invention. With the use of the plasma CVD device 1, the coated member 20 can be produced by the DC pulse plasma CVD process or the DC plasma CVD process.

The illustrated plasma CVD device 1 includes a treatment chamber 3 surrounded by a partition wall 2, a base platform 5 which retains a base 4 for the coated member 20 in the treatment chamber 3, a feedstock gas introduction pipe 6 through which a feedstock gas is introduced into the treatment chamber 3, an evacuation system 7 which evacuates the treatment chamber 3 to vacuum, and a power source 8 which generates a DC pulse voltage or a DC voltage for generating plasma from the gas introduced into the treatment chamber 3.

The base platform 5 includes horizontal support plates 9, and a vertical support shaft 10 supporting the support plates 9. In this embodiment, a three-stage base platform including three support plates 9 vertically arranged, for example, is used as the base platform 5.

The base platform 5 is entirely made by using an electrically conductive material such as copper. A negative electrode of the power source 8 is connected to the base platform 5.

The partition wall 2 of the treatment chamber 3 is made by using an electrically conductive material such as stainless steel. A positive electrode of the power source 8 is connected to the partition wall 2. The partition wall 2 is grounded. The partition wall 2 and the base platform 5 are insulated from each other by an insulation member 11. Thus, the partition wall 2 is maintained at a ground potential. When the power source 8 is turned on to generate the DC pulse voltage or the DC voltage, a potential difference is generated between the partition wall 2 and the base platform 5.

The feedstock gas introduction pipe 6 extends horizontally above the base platform 5 in the treatment chamber 3. The feedstock gas introduction pipe 6 has a multiplicity of feedstock gas outlet ports 12 arranged longitudinally of the feedstock gas introduction pipe 6 in opposed relation to the base platform 5. The feedstock gas is spouted from the feedstock gas outlet ports 12 to be thereby introduced into the treatment chamber 3.

The feedstock gas, which contains a carbon compound and an oxygen-containing organic silicon compound as component gases, is supplied into the feedstock gas introduction pipe 6. A plurality of branch introduction pipes (not shown) for supplying the respective component gases from supply sources of the component gases (gas cylinders, liquid-containing containers or the like) are connected to the feedstock gas introduction pipe 6. Flow rate control valves (not shown) for controlling the flow rates of the component gases to be supplied from the respective supply sources are provided in the respective branch introduction pipes. Where a container containing a liquid is employed as any of the supply sources, the supply source is provided with heating means (not shown) for heating the liquid as required.

The evacuation system 7 includes a first evacuation pipe 13 and a second evacuation pipe 14 each communicating with the treatment chamber 3, a first on-off valve 15, a second on-off valve 16, a third on-off valve 19, a first pump 17 and a second pump 18.

The first on-off valve 15 and the first pump 17 are provided in this order from the treatment chamber 3 in the first evacuation pipe 13. A low-vacuum pump such as an oil rotary vacuum pump (rotary pump) or a diaphragm vacuum pump is used as the first pump 17. The oil rotary vacuum pump is a positive displacement vacuum pump in which airtight spaces and void spaces defined between a rotor, a stator, slidable vanes and other parts are reduced with oil. Examples of the oil rotary vacuum pump to be employed as the first pump 17 include a sliding vane rotary vacuum pump and a rotary plunger vacuum pump .

A distal end of the second evacuation pipe 14 is connected to a part of the first evacuation pipe 13 between the first on-off valve 15 and the first pump 17. The second on-off valve 16, the second pump 18 and the third on-off valve 19 are provided in this order from the treatment chamber 3 in the second evacuation pipe 14. A high-vacuum pump such as a turbo molecular pump or an oil diffusion pump is used as the second pump 18.

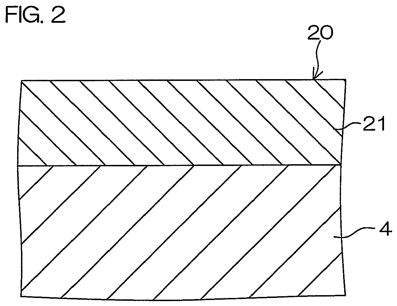

FIG. 2 is a sectional view illustrating a subsurface portion of the coated member 20 produced by the production method using the plasma CVD device 1.

Referring to FIG. 2, the coated member 20 includes a base 4 and a DLC film 21 formed on a surface of the base 4.

Where the coated member 20 is any of various slidable members to be mounted in motor vehicles, for example, exemplary materials for the base 4 include various steels such as tool steels, carbon steels and stainless steels.

For the slidable member, the DLC film 21 has a Si content of, for example, not lower than 7 mass% and not higher than 30 mass%, particularly about 20 mass%, in consideration of the effect of improving the initial adaptability previously described. The DLC film 21 has a film thickness of, for example, about 0.1 to about 10.0 $\mu$m. Provided that the peel strength of the DLC film 21 with respect to the base 4 is defined as a peel starting load with which Mode-2 "local peeling" occurs in the scratch test specified in JSME S010 (1996) by the Japan Society of Mechanical Engineers, the DLC film 21 has a peel starting load of, for example, not less than 25 N.

For the production of the coated member 20 by forming the DLC film 21 on the surface of the base 4 by means of the plasma CVD device 1, the base 4 is set on one of the support plates 9 of the base platform 5 in the treatment chamber 3, and then the treatment chamber 3 is closed.

With the first, second and third on-off valves 15, 16, 19 closed, the first pump 17 is driven, and then the treatment chamber 3 is evacuated to vacuum by opening the first on-off valve 15. When the treatment chamber 3 is evacuated to a predetermined degree of vacuum by the first pump 17, the second pump 18 is driven with the first on-off valve 15 closed and with the third on-off valve 19 open, and then the treatment chamber 3 is further evacuated by the first and second pumps 17, 18 by opening the second on-off valve 16.

When the treatment chamber 3 is evacuated to a predetermined degree of vacuum, the second on-off valve 16 is closed, and the second pump 18 is stopped. Then, the feedstock gas is introduced into the treatment chamber 3 from the supply sources not shown through the feedstock gas introduction pipe 6, while the treatment chamber 3 is continuously evacuated only by the first pump 17 with the third on-off valve 19 closed and with the first on-off valve 15 open.

A gas mixture prepared, for example, by adding hydrogen gas and argon gas to the carbon compound and the oxygen-containing organic silicon compound is used as the feedstock gas. The hydrogen gas and the argon gas function to stabilize the plasma. The argon gas also functions to harden the DLC film 21 by compacting C deposited on the surface of the base 4.

Examples of the carbon compound include hydrocarbon compounds such as methane ($CH_4$), acetylene ($C_2H_2$) and benzene ($C_6H_6$) which are in a gas or liquid phase under ordinary temperature and ordinary pressure conditions. These hydrocarbon compounds may be used either alone or in combination. The oxygen-containing organic silicon compound is a siloxane compound which has an oxygen atom at a given site in a molecule thereof. These oxygen-containing organic silicon compounds may be used either alone or in combination.

Preferred examples of the siloxane compound include hexamethyldisiloxane ($(CH_3)_3Si\text{-}O\text{-}Si(CH_3)_3$ having a boiling point of 100°C at an ordinary pressure) and 1,1,3,3-tetramethyldisiloxane ($(CH_3)_2SiH\text{-}O\text{-}SiH(CH_3)_2$ having a boiling point of 71°C at an ordinary pressure).

Among these oxygen-containing organic silicon compounds, hexamethyldisiloxane is particularly preferred for the aforementioned reasons.

While the flow rate ratio of the respective component gases and the overall flow rate of the feedstock gas (which is a gas mixture of the respective component gases) are controlled by controlling the flow rate control valves provided in the blanch introduction pipes (not shown) for the respective component gases, the feedstock gas is introduced into the treatment chamber 3 through the feedstock gas introduction pipe 6 with the treatment pressure in the treatment chamber 3 controlled at not lower than 100 Pa and not higher than 400 Pa.

If the treatment pressure is lower than 100 Pa, the amount of the feedstock gas introduced into the treatment chamber 3 is reduced to reduce the film forming rate of the DLC film 21. Therefore, a longer period is required for the formation of the DLC film 21 having the predetermined thickness.

This makes it impossible to achieve the intended purpose of further improving the productivity of the coated member 20 over the current state of the art by increasing the film forming rate of the DLC film 21 as much as possible, and minimizing the damage to the base 4 of the coated member 20.

If the treatment pressure is higher than 400 Pa, it is impossible to stably generate the plasma, so that the DLC film 21 cannot be properly formed as having a uniform density, excellent friction property and excellent wear resistance.

Provided that the ratio of the total flow rate of the carbon compound, the hydrogen gas and the argon gas to a reference flow rate is controlled to 2.20, the flow rate of the oxygen-containing organic silicon compound out of the component gases is preferably controlled to not less than 0.01 and not greater than 0.12, particularly preferably not less than 0.03 and not greater than 0.06, based on a total flow rate of 2.20 in order to control the Si content of the DLC film 21 within the proper range described above.

If the flow rate of the oxygen-containing organic silicon compound is less than the aforementioned range, the effect of increasing the DLC film forming rate is not sufficiently provided by the addition of the oxygen-containing organic silicon compound to the gas mixture. This may make it impossible to achieve the intended purpose of further improving the productivity of the coated member 20 over the current state of the art, and minimizing the damage to the base 4 of the coated member 20. Further, it may also be impossible to sufficiently provide the effect of improving the initial adaptability of the DLC film 21 by allowing the DLC film 21 to have a Si content in the aforementioned preferred range.

If the flow rate of the oxygen-containing organic silicon compound is greater than the aforementioned range, the film forming rate is excessively high, so that the density of the DLC film 21 and the peel strength of the DLC film 21 with respect to the base 4 are liable to be reduced. Further, the DLC film 21 tends to become softer, as the Si content of the DLC film increases. This may result in a possibility that the DLC film 21 cannot be properly formed as having a uniform density, and excellent peel strength, friction property and wear resistance.

Further, there is a possibility that a great amount of particles mainly containing excess Si are generated in the treatment chamber 3, while the DLC film 21 is formed on the surface of the base 4. The particles are liable to be incorporated in the DLC film 21 to thereby reduce the density and the uniformity of the DLC film 21 or reduce the peel strength of the DLC film 21 with respect to the base 4. Further, the particles are liable to intrude into components of the plasma CVD device 1 to hamper the functions of the respective components. In order to prevent these problems, a particle removing step is required. As a result, the productivity of the coated member 20 is liable to be reduced.

The flow rate of the carbon compound is preferably controlled to about 50 % of a total flow rate of 2.20 of the carbon compound, the hydrogen gas and the argon gas.

In turn, the power source 8 is turned on to generate a potential difference between the partition wall 2 and the base platform 5, whereby the plasma is generated in the treatment chamber 3.

In the DC pulse plasma CVD process, for example, the power source 8 is turned on, whereby the DC pulse voltage is applied between the partition wall 2 and the base platform 5 to generate the plasma. By the generation of the plasma, ions and radicals are generated from the feedstock gas in the treatment chamber 3, and attracted to the surface of the base 4 due to the potential difference. Then, chemical reactions occur on the surface of the base 4, whereby the DLC film 21 is deposited on the surface of the base 4 as containing C as a major component and Si.

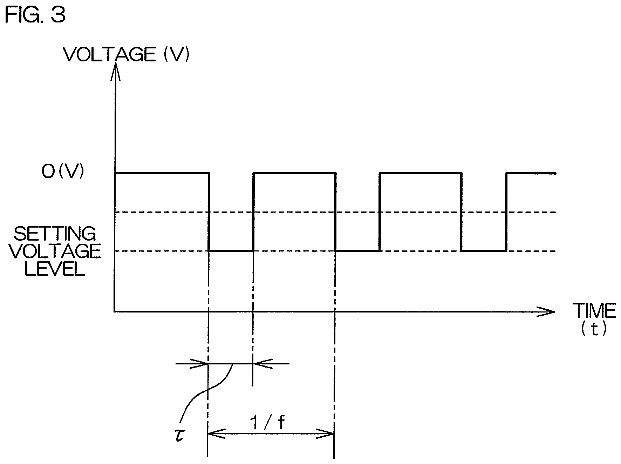

FIG. 3 is a graph showing an exemplary waveform of the DC pulse voltage applied to the base 4 from the power source 8. The DC pulse voltage is set, for example, at a setting voltage level of about -1000 V. That is, when the power source 8 is turned on, a potential difference of 1000 V is generated between the partition wall 2 and the base platform 5. In other words, a negative DC pulse voltage of 1000 V is applied to the base 4 set on the base platform 5, and the base 4 functions as a negative electrode. Since the DC pulse voltage has a pulse waveform, even the application of such a high voltage never causes abnormal electric discharge in the treatment chamber 3. This suppresses the temperature elevation of the base 4, making it possible to control the treatment temperature to not higher than 300°C.

For the DC pulse voltage, a duty ratio obtained by dividing the pulse width $\tau$ by the pulse period represented as a reciprocal (1/f) of the frequency f, i.e., by multiplying the pulse width $\tau$ by the frequency f as indicated by the following equation (1), is preferably set to not less than 5 %, particularly preferably about 50 %. The frequency f is preferably set to not lower than 200 Hz and not higher than 2000 Hz, particularly preferably about 1000 Hz.

This further improves the film forming rate of the DLC film 21, thereby improving the productivity of the coated member 20 over the current state of the art and minimizing the damage to the base 4 of the coated member 20.

$$Duty\ ratio = \tau \times f\ ...(1)$$

In this embodiment, the DC plasma CVD process may be employed instead of the DC pulse plasma CVD process. That is, the power source 8 is turned on, whereby the DC voltage is applied between the partition wall 2 and the base platform 5 to generate the plasma. By the generation of the plasma, ions and radicals are generated from the feedstock gas in the treatment chamber 3, and attracted to the surface of the base 4 due to the potential difference. Then, chemical reactions occur on the surface of the base 4, whereby the DLC film 21 is deposited on the surface of the base 4 as containing C as a major component and Si.

This process also increases the film forming rate of the DLC film 21, thereby further improving the productivity of the coated member 20 over the current state of the art. Although there is a possibility of temperature elevation, the damage to the base 4 of the coated member 20 can be reduced.

When the DLC film 21 is formed as having the predetermined thickness on the surface of the base 4 by performing the DLC film forming step, the power source 8 is turned off, and the introduction of the feedstock gas is stopped. Then, the treatment chamber is cooled to the ordinary temperature while being evacuated by the first pump 17. Subsequently, the first on-off valve 15 is closed and, instead, a leak valve not shown is opened to introduce outside air into the treatment chamber 3 to return the internal pressure of the treatment chamber 3 to the ordinary pressure. Then, the base 4 is taken out with the treatment chamber open. Thus, the coated member 20 with the surface of the base 4 at least partly coated with the DLC film 21 is produced.

Examples of the coated member 20 include a clutch plate for a friction clutch, a worm (having tooth surfaces coated with the DLC film) for a steering device, inner and outer rings (having raceway surfaces coated with the DLC film) for a bearing, a bearing cage, and a propeller shaft (having a drive shaft, a male spline and/or a female spline coated with the DLC film).

Prior to the formation of the DLC film 21 on the surface of the base 4 by performing the DC pulse plasma CVD process or the DC plasma CVD process, the surface of the base 4 may be subjected to an ion bombardment process. Where the ion bombardment process is performed, the power source 8 is turned on with the argon gas and the hydrogen gas being introduced into the treatment chamber 3 to generate plasma. By the generation of the plasma, ions and radicals are generated from the argon gas in the treatment chamber 3 to bombard the surface of the base 4 due to a potential difference. This makes it possible to sputter off foreign molecules adsorbed on the surface of the base 4, activate the surface, and modify the atomic arrangement of the surface.

Thus, the DLC film 21 formed by subsequently performing the plasma CVD process has a higher peel strength, and are further improved in friction property and wear resistance.

The DLC film 21 is not formed directly on the surface of the base 4, but an intermediate layer such as of a nitride (e.g., SiN, CrN or the like), Cr, Ti or SiC may be provided between the surface of the base 4 and the DLC film 21.

Next, Examples and Comparative Examples will be described.

In Examples and Comparative Examples, coated members were each produced by forming a DLC film on a surface of a base 4 made of a tool steel (SKH4) by means of the plasma CVD device 1 shown in FIG. 1.

In Examples, a gas mixture containing methane as the carbon compound, hexamethyldisiloxane as the oxygen-containing organic silicon compound, hydrogen gas and argon gas was used as the feedstock gas. In Comparative Example 1, tetramethylsilane was used instead of hexamethyldisiloxane as the silane compound.

The flow rate ratio of methane, hydrogen gas and argon gas out of the above component gases was 1.00:0.60:0.60, and the total flow rate ratio of these three components was 2.20.

In Examples, the flow rate ratio of hexamethyldisiloxane was controlled to 0.03 (Example 1) and 0.06 (Example 2) with respect to a total flow rate ratio of 2.20 of the above three components. In Comparative Example, the flow rate ratio of tetramethylsilane was controlled to 0.06 with respect to a total flow rate ratio of 2.20 of the above three components.

A power source capable of generating a DC pulse voltage was used as the power source 8, and the DC pulse voltage was controlled to have a setting voltage level of -1000 V, a frequency f of 1000 Hz and a duty ratio of 50 %.

The treatment chamber 3 was evacuated to vacuum in the aforementioned manner, and then the power source 8 was turned on with only the argon gas being introduced into the treatment chamber 3 to generate plasma in the treatment chamber 3. Thus, the ion bombardment process was performed. Then, the feedstock gas was introduced into the treatment chamber 3, and the treatment pressure in the treatment chamber 3 was controlled to 400 Pa. In turn, the power source 8 was turned on again to generate plasma in the treatment chamber 3, whereby the DLC film 21 was formed on the surface of the base 4 by the DC pulse plasma CVD process.

The surface roughnesses Ra, $Rz_{JIS}$ (Japanese Industrial Standards JIS B0601:2001), the plasticity, the peel starting load (JSME S010 (1996) specified by the Japan Society of Mechanical Engineers), the nitriding depth and the film thickness of the DLC film thus formed were measured. The film forming rate per hour was determined based on the film formation period and the film thickness.

The results are shown in Table 1.

Table 1

| | Comparative Example 1 | Example 1 | Example 2 |
|---|---|---|---|
| Flow rate (ratio) | | | |
| Tetramethylsilane | 0.06 | - | - |
| Hexamethyldisiloxane | - | 0.03 | 0.06 |
| Other three components | 2.20 | 2.20 | 2.20 |
| Surface roughnesses | | | |
| Ra ($\mu$m) | 0.012 | 0.015 | 0.040 |
| $Rz_{JIS}$($\mu$m) | 0.045 | 0.106 | 0.283 |
| Formulation (mass%) | | | |
| C | 81.0 | 91.37 | 80.08 |
| Si | 18.9 | 7.25 | 19.85 |
| Others | 0.1 | 1.38 | 0.03 |
| Peel starting load (N) | 39.7 | 25.3 | 28.2 |
| Nitriding depth ($\mu$m) | 45 | | |
| Film thickness ($\mu$m) | 3.3 | 3.9 | 6.3 |
| Film forming rate ($\mu$m/h) | 4.4 | 5.2 | 8.4 |

It was confirmed from Table 1 that, where hexamethyldisiloxane as the oxygen-containing organic silane compound is used instead of tetramethylsilane as the silane compound, the film forming rate of the DLC film can be improved.

In Comparative Example 2, a coated member was produced by forming a DLC film on a surface of a base 4 of a tool steel (SKH4) by the DC plasma CVD process. In Comparative Example 2, a gas mixture containing methane as the carbon compound, tetramethylsilane as the silane compound, hydrogen gas and argon gas was used as the feedstock gas. The flow rate ratio of methane, hydrogen gas and argon gas out of the above component gasses was 1.00:0.60:0.60. The flow rate ratio of tetramethylsilane was controlled to 0.06 with respect to a total flow rate ratio of 2.20 of the above three components. The DC voltage setting level was -1000 V, and the treatment pressure was controlled at 50 to 400 Pa.

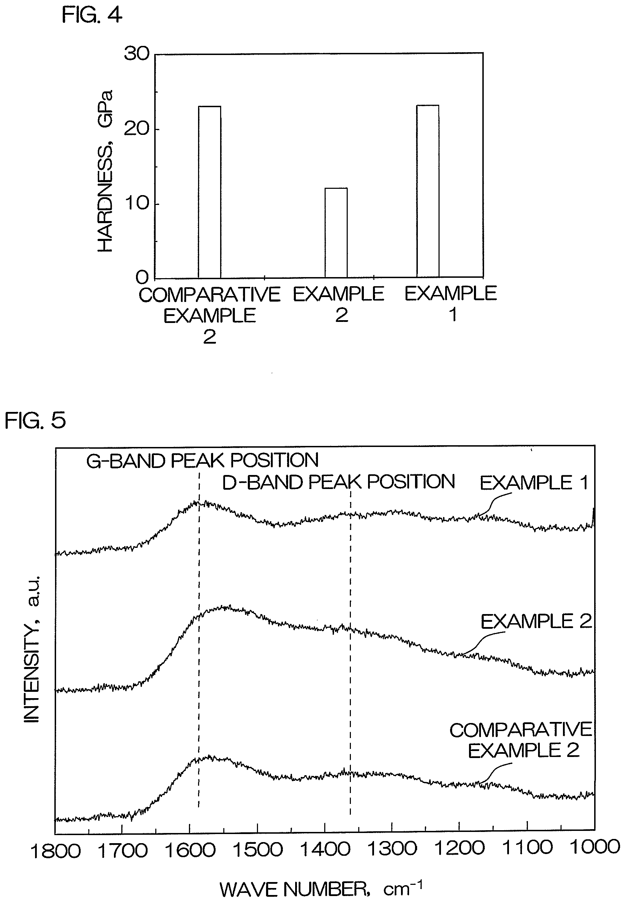

FIG. 4 is a graph showing the nano-indention hardnesses of DLC films of the coated members produced in Examples 1 and 2 and Comparative Example 2. In the following description, the DLC film 21 of the coated member 20 produced in Example 1 will be referred to as the DLC film 21 of Example 1, and the DLC film 21 of the coated member 20 produced in Example 2 will be referred to as the DLC film 21 of Example 2. Further, the DLC film of the coated member produced in Comparative Example 2 will be referred to as the DLC film of Comparative Example 2.

The DLC film 21 of Example 2 had a sufficient hardness, but was slightly softer than the DLC film of Comparative Example 2. On the other hand, the DLC film 21 of Example 1 had substantially the same hardness as the DLC film of Comparative Example 2. This indicates that a DLC film having an excellent hardness comparable to that of the DLC film formed in a higher temperature environment by using the silane compound for the feedstock gas can be produced by the production method of Example 1. This also indicates that a DLC film having a sufficient hardness can be produced by the production method of Example 2.

In the meanwhile, the DLC film has a structure such that a graphite bond ($sp^2$ bond) and an amorphous structure are present together. The characteristic properties (physical properties) of the DLC film significantly depend on the ratio of the graphite bond and the amorphous structure present in the DLC film.

The waveform of a Raman spectrum of the DLC film measured by the Raman spectroscopy can be divided into a D-band having a peak at about 1350 cm$^{-1}$ and a G-band having a peak at about 1580 cm$^{-1}$. The G-band indicates the presence of the $sp^2$ bond (graphite bond), while the D-band indicates the presence of a trace of a broken $sp^2$ bond. The presence of the D-band indicates that the DLC film has an amorphous structure.

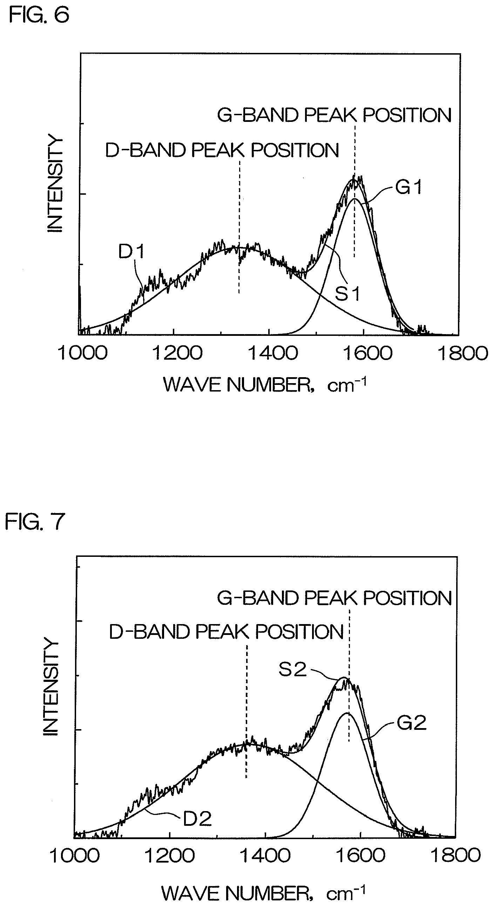

FIG. 5 is a graph showing exemplary Raman spectra of the DLC films of Examples and Comparative Example. FIG. 6 is a graph showing a Raman spectrum of the DLC film 21 of Example 1 with its waveform divided into the G-band and the D-band. FIG. 7 is a graph showing a Raman spectrum of the DLC film of Comparative Example 2 with its waveform divided into the G-band and the D-band.

In FIG. 5, the Raman spectra of the DLC films of Examples 1 and 2 and Comparative Example 2 are shown together as vertically arranged. The Raman spectra each have a minimum intensity at about 1800 cm$^{-1}$. FIG. 5 shows that the Raman spectra each have peaks at a G-band peak position and at a D-band peak position.

FIGS. 6 and 7 show the original Raman spectra as well as fitting curves S1, S2 of the entire Raman spectra, G-band fitting curves G1, G2 and D-band fitting curves D1, D2 of the Raman spectra. In other words, the fitting curves S1, S2 of the entire Raman spectra each have a waveform obtained by adding the waveform of the G-band fitting curve G1, G2 to the waveform of the D-band fitting curve D1, D2.

The fitting curves S1, S2, G1, G2, D1, D2 were obtained by a common curve fitting method, for example, by fitting the Raman Spectra with a plurality of Gaussian functions or Lorentz functions.

As can be understood from FIGS. 6 and 7, the peak intensity ratio of the DLC film 21 of Example 1 is substantially equal to the peak intensity ratio of the DLC film of Comparative Example 2. Therefore, a DLC film having an excellent hardness comparable to that of the DLC film formed in the higher temperature environment by using the silane compound for the feedstock gas can be produced by the production method of Example 1.

While the present invention has been described in greater detail by way of the specific embodiments thereof, those skilled in the art who understand the above disclosure will easily conceive alterations, modifications and equivalents of the embodiments. Therefore, the scope of the present invention should be construed as being defined by the claims.

REFERENCE SIGNS LIST

1: PLASMA CVD DEVICE, 2: PARTITION WALL, 3: TREATMENT CHAMBER, 4: BASE, 5: BASE PLATFORM, 6: FEEDSTOCK GAS INTRODUCTION PIPE, 7: EVACUATION SYSTEM 8: POWER SOURCE, 9: SUPPORT PLATE, 10: SUPPORT SHAFT, 11: INSULATION MEMBER, 12: FEEDSTOCK GAS OUTLET PORTS, 13: FIRST EVACUATION PIPE, 14: SECOND EVACUATION PIPE, 15: FIRST ON-OFF VALVE, 16: SECOND ON-OFF VALVE, 17: FIRST PUMP, 18: SECOND PUMP, 19: THIRD ON-OFF VALVE, 20: COATED MEMBER, 21: DLC FILM

## Claims

1. A coated member (20) production method for producing a coated member (20) including a base (4) having a surface at least partly coated with a DLC film (21), the method comprising a DLC film (21) forming step of

   the base (4) is accommodated in a treatment chamber (3),
   the treatment chamber (3) is evacuated to a predetermined degree of vacuum by the first pump (17),
   the treatment chamber (3) is evacuated to a predetermined degree of vacuum by the first and second pumps (17, 18),
   the second pump (18) is stopped and the treatment chamber (3) is continuously evacuated only by the first pump (17),
   introducing a feedstock gas containing at least a carbon compound and a siloxane compound into a treatment chamber (3) in which the base (4) is accommodated, and
   applying a voltage to the base (4) at a treatment pressure of not lower than 100 Pa and not higher than 400 Pa to generate plasma to form the DLC film (21) on the surface of the base (4).

2. The coated member (20) production method according to claim 1, wherein the siloxane compound is hexamethyldisiloxane.

3. The coated member (20) production method according to claim 1 or 2, wherein the plasma is generated by applying a DC pulse voltage to the base (4) in the DLC film (21) forming step.

## Patentansprüche

1. Verfahren zur Herstellung eines beschichteten Elements (20), das eine Basis (4) mit einer Oberfläche aufweist, die zumindest teilweise mit einem DLC-Film (21) beschichtet ist, wobei das Verfahren einen DLC-Film (21)-Bildungsschritt umfasst von

   die Basis (4) wird in einer Behandlungskammer (3) untergebracht,
   die Behandlungskammer (3) wird durch die erste Pumpe (17) auf einen bestimmten Vakuumgrad evakuiert,
   die Behandlungskammer (3) durch wird die erste und zweite Pumpen (17, 18) auf einen bestimmten Vakuumgrad evakuiert,
   die zweite Pumpe (18) wird gestoppt und die Behandlungskammer (3) wird nur von der ersten Pumpe (17) kontinuierlich evakuiert,
   Einleiten eines Rohstoffgases, das zumindest eine Kohlenstoffverbindung und eine Siloxanverbindung enthält, in eine Behandlungskammer (3), in der die Basis (4) untergebracht ist, und

Anlegen einer Spannung an die Basis (4) bei einem Behandlungsdruck von nicht weniger als 100 Pa und nicht mehr als 400 Pa zur Erzeugung von Plasma, um den DLC-Film (21) auf der Oberfläche der Basis (4) zu bilden.

2. Verfahren zur Herstellung eines beschichteten Elements (20) nach Anspruch 1, wobei die Siloxanverbindung Hexamethyldisiloxan ist.

3. Verfahren zur Herstellung eines beschichteten Elements (20) nach Anspruch 1 oder 2, wobei das Plasma durch Anlegen einer Gleichstromimpulsspannung an die Basis (4) im DLC-Film (21)-Bildungsschritt erzeugt wird.

**Revendications**

1. Procédé de production d'élément revêtu (20) pour produire un élément revêtu (20) incluant une base (4) ayant une surface au moins partiellement revêtue avec un film DLC (21), le procédé comprenant une étape formant un film DLC (21) de
la base (4) est logée dans une chambre de traitement (3),
la chambre de traitement (3) est mise sous vide à un degré de vide prédéterminé par la première pompe (17),
la chambre de traitement (3) est mise sous vide jusqu'à un degré de vide prédéterminé par les première et seconde pompes (17, 18),
la seconde pompe (18) est arrêtée et la chambre de traitement (3) est mise sous vide en continu uniquement par la première pompe (17),
introduisant un gaz de réserve contenant au moins un composé de carbone et un composé de siloxane dans une chambre de traitement (3) dans laquelle la base (4) est logée, et
appliquant une tension à la base (4) à une pression de traitement qui n'est pas inférieure à 100 Pa et n'est pas supérieure à 400 Pa pour produire un plasma pour former le film DLC (21) sur la surface de la base (4).

2. Procédé de production d'élément revêtu (20) selon la revendication 1, dans lequel le composé de siloxane est l'hexaméthyldisiloxane.

3. Procédé de production d'élément revêtu (20) selon la revendication 1 ou 2, dans lequel le plasma est produit par application d'une tension pulsée DC à la base (4) dans l'étape formant un film DLC (21).

FIG. 1

FEEDSTOCK GAS
OR
HYDROGEN GAS

POWER
SOURCE

EVACUATION

EP 2 578 726 B1

FIG. 2

FIG. 3

VOLTAGE (V)

0 (V)

SETTING
VOLTAGE
LEVEL

TIME
( t )

$\tau$

1 / f

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009185336 A
- JP 2008173936 B